# EUROPEAN PATENT APPLICATION

(11) **EP 4 579 399 A1**
(43) Date of publication of application: **02.07.2025**
(21) Application number: 23942630.7
(22) Date of filing: 31.10.2023
(51) Int. Cl.: G06F 3/01

(54) **HAPTIC ACTUATOR**

(71) Applicant: LG Electronics Inc., Seoul, 07336 (KR)
(72) Inventor: MOON, Saseong, Seoul 06772 (KR); BAE, Hyejin, Seoul 06772 (KR)
(74) Representative: Vossius & Partner Patentanwälte Rechtsanwälte mbB
(86) International application number: PCT/KR2023/017072
(87) International publication number: WO 2025/095157

(57) **Abstract**

A haptic actuator located at a back surface of a display panel includes: a piezoelectric element driven to generate vibration; and an amplifying member having the piezoelectric element attached to a back surface thereof and configured to amplify vibration caused by driving of the piezoelectric element and transmit the amplified vibration to the display panel. The amplifying member is configured such that both corners in a first direction are attached to the back surface of the display panel and a front surface of the amplifying member is spaced apart from the back surface of the display panel to form a gap. The amplifying member having a piezoelectric element attached to the back surface thereof is located at the back surface of the display panel, thereby amplifying vibration generated by driving of the piezoelectric element.

## Description

### [Technical Field]

The present disclosure relates to a haptic actuator having an amplifying member for amplifying vibration caused by driving a piezoelectric element and transmitting the amplified vibration to a display panel.

### [Background Art]

With the development of computer-based systems, the ease of interface between humans and machines is becoming more important. The interface between humans and machines should be intuitive and easy to use for anyone. Among interface devices, a touchscreen or touchpad is the most intuitive and easy to use.

The touchscreen includes a panel capable of tactile sensing and a display device. In general, a touchscreen can manipulate the position and function of a pointer installed therein by directly touching the screen from the outside.

Meanwhile, the development of haptic feedback generation devices is actively underway to provide haptic feedback to touchscreens. Here, haptics is a tactile sensation that can be felt with the tip of a person's finger that touches an object, and is a concept that includes tactile feedback felt when the skin touches the surface of an object and kinesthetic force feedback felt when the movement of joints and muscles is interrupted.

In particular, vibration effects, or vibrotactile haptic effects, may be useful for alerting users to specific events or providing realistic feedback to create greater sensory immersion in a simulated or virtual environment.

There is a piezoelectric element as a member that is applied to haptic technology for providing haptic feedback to users. The piezoelectric element is a component that implements the piezoelectric effect in which a voltage is generated when mechanical deformation is applied from the outside to the piezoelectric element or vibration is generated when the piezoelectric element is expanded or contracted upon receiving such voltage.

However, since the piezoelectric element has a limitation in vibration that may occur depending on the material and shape of the piezoelectric element or the magnitude of voltage to be applied to the piezoelectric element, a means for efficiently generating larger vibrations is required.

### [Disclosure]

### [Technical Problem]

An object of the present disclosure is to provide a haptic actuator capable of amplifying vibration caused by driving a piezoelectric element by positioning an amplifying member having the piezoelectric element attached to a back surface thereof on a back surface of a display panel.

Another object of the present disclosure is to provide a haptic actuator capable of amplifying vibration caused by driving the piezoelectric element through various shapes of a haptic actuator in which both corners of the amplifying member are attached to the back surface of the display panel and a front surface of the amplifying member can be spaced apart from the back surface of the display panel.

Another object of the present disclosure is to provide a haptic actuator capable of amplifying vibration caused by driving the piezoelectric element while reducing a thickness of the amplifying member.

It will be appreciated by persons skilled in the art that the objects that could be achieved with the present disclosure are not limited to what has been particularly described hereinabove and the above and other objects that the present disclosure could achieve will be more clearly understood from the following detailed description.

### [Technical Solutions]

In accordance with an aspect of the present disclosure, a haptic actuator located at a back surface of a display panel may include: a piezoelectric element driven to generate vibration; and an amplifying member having the piezoelectric element attached to a back surface thereof and configured to amplify vibration caused by driving of the piezoelectric element and transmit the amplified vibration to the display panel, wherein the amplifying member is configured such that both corners in a first direction are attached to the back surface of the display panel and a front surface of the amplifying member is spaced apart from the back surface of the display panel to form a gap.

The amplifying member may be bent to have a predetermined radius of curvature; and a thickness of the amplifying member increases in a direction from a center portion to corners of both sides of the amplifying member so that attachment surfaces of the corners of both sides of the amplifying member are parallel to the back surface of the display panel.

The piezoelectric element may be bent to have a same radius of curvature as the amplifying member.

A vertical distance from the back surface of the display panel to a back surface of the piezoelectric element is 5 millimeters or less.

The radius of curvature of the amplifying member is 133 millimeters or more.

The amplifying member may include: a flat portion where the back surface is formed flat; and a support portion formed to be bent at a boundary of both sides of the flat portion so that attachment surfaces of the corners of both sides of the amplifying member are parallel to the back surface of the display panel.

The support portion may be bent to have a predetermined radius of curvature at a boundary of both sides of the flat portion, wherein the radius of curvature of the support portion is less than or equal to half a wavelength of the vibration generated by the piezoelectric element.

The support portion may be vertically bent at a boundary of both sides of the flat portion, wherein a thickness of the support portion is 1 millimeter or more and less than or equal to half a wavelength of the vibration generated by the piezoelectric element.

A vertical distance from the back surface of the display panel to the front surface of the flat portion may be less than or equal to half a wavelength of the vibration generated by the piezoelectric element.

The haptic actuator may further include: at least one support leg formed vertically on a front surface of the flat portion and attached to the back surface of the display panel.

The flat portion may be formed so that a thickness of a center portion of the flat portion is different from a thickness of a boundary of both sides of the flat portion.

The piezoelectric element may have a thickness of 0.3 mm to 0.5 mm.

A length of the piezoelectric element in the first direction is 30 millimeters.

The amplifying member may include a metal material or a plastic material.

The haptic actuator may further include an adhesive member configured to attach the piezoelectric element to the back surface of the amplifying member and to attach corners of both sides of the amplifying member to the back surface of the display panel.

The display panel may be a plastic organic light emitting diode (POLED) panel.

### [Advantageous Effects]

As is apparent from the above description, the haptic actuator according to the present disclosure can amplify vibration caused by driving a piezoelectric element by positioning the amplifying member having the piezoelectric element attached to the back surface thereof on the back surface of the display panel.

The embodiments of the present disclosure can amplify vibration caused by driving the piezoelectric element through various shapes of the haptic actuator in which both corners of the amplifying member are attached to the back surface of the display panel and a front surface of the amplifying member can be spaced apart from the back surface of the display panel.

In addition, the present disclosure can provide a haptic actuator capable of amplifying vibration caused by driving a piezoelectric element while reducing a thickness of the amplifying member.

Effects obtainable from the present embodiments are not limited by the above mentioned effects, and other unmentioned effects can be clearly understood from the above description by those having ordinary skill in the technical field to which the present disclosure pertains.

### [Description of Drawings]

FIG. 1 a block diagram illustrating each configuration of a display device.
FIG. 2 is an exploded view of a display device according to an embodiment of the present disclosure.
FIG. 3 is a view of a display device according to an embodiment of the present disclosure as viewed from the rear.
FIG. 4 is a cross-sectional view illustrating a comparison between a conventional display device and a display device according to an embodiment of the present disclosure.
FIG. 5 is a diagram illustrating a pattern printed on a rear surface of an optical substrate in a display device according to an embodiment of the present disclosure.
FIG. 6 is a cross-sectional view illustrating another embodiment of a display device of the present disclosure.
FIG. 7 is a view illustrating a reinforcing member attached to a rear surface of the cover panel in the display device according to an embodiment of the present disclosure.
FIG. 8 is a view illustrating a support bar for fixing the support panel in the display device according to an embodiment of the present disclosure.

### [Best Mode]

Description will now be given in detail according to exemplary embodiments disclosed herein, with reference to the accompanying drawings. The same or equivalent components may be provided with the same reference numbers, and description thereof will not be repeated. As used herein, the suffixes "module" and "part" are added or used interchangeably to facilitate preparation of this specification and are not intended to suggest distinct meanings or functions. In describing embodiments disclosed in this specification, relevant well-known technologies may not be described in detail in order not to obscure the subject matter of the embodiments disclosed in this specification. In addition, it should be noted that the accompanying drawings are only for easy understanding of the embodiments disclosed in the present specification, and should not be construed as limiting the technical spirit disclosed in the present specification. As such, the present disclosure should be construed to extend to any alterations, equivalents and substitutes in addition to those which are particularly set out in the accompanying drawings.

Although the terms first, second, etc. may be used herein to describe various elements, these elements should not be limited by these terms. These terms are generally only used to distinguish one element from another.

It will be understood that when an element is referred to as being "connected with" another element, the element can be directly connected with the other element or intervening elements may also be present. In contrast, it will be understood that when an element is referred to as being "directly connected with" another element, there are no intervening elements present.

A singular representation may include a plural representation unless it represents a definitely different meaning from the context.

The terms such as "include" or "have" used herein are intended to indicate that features, numbers, steps, operations, elements, components, or combinations thereof used in the following description exist and it should be thus understood that the possibility of existence or addition of one or more different features, numbers, steps, operations, elements, components, or combinations thereof is not excluded.

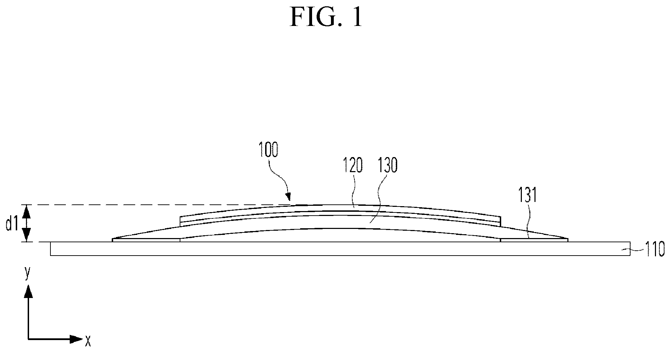

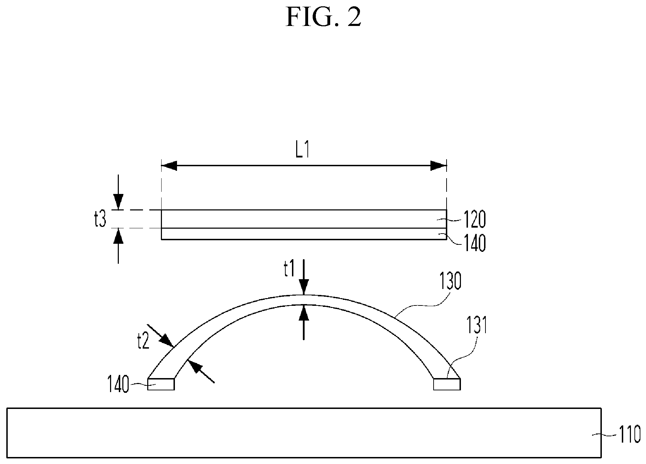

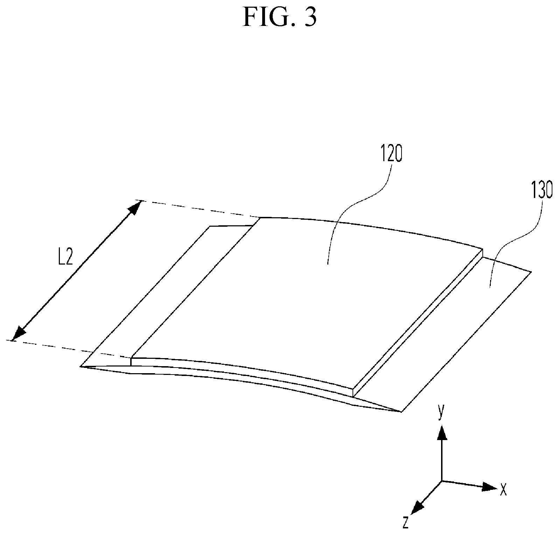

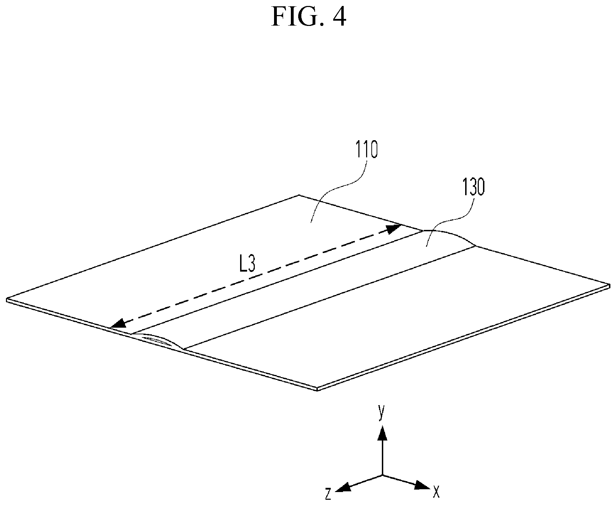

FIG. 1 is a diagram illustrating a haptic actuator 100 according to one embodiment of the present disclosure. FIG. 2 is an exploded view illustrating the haptic actuator 100 according to one embodiment of the present disclosure. FIGS. 3 and 4 are diagrams illustrating dimensions of a piezoelectric element 120 for use in the haptic actuator 100 according to one embodiment of the present disclosure.

Hereinafter, in explaining the haptic actuator 100 according to one embodiment of the present disclosure, a first direction, which is a left-right direction, will hereinafter be referred to as an X-axis direction, a direction toward the back surface of the haptic actuator will hereinafter be referred to as a Y-axis direction, and a direction perpendicular to the first direction will hereinafter be referred to as a Z-axis direction.

The haptic actuator 100 according to one embodiment of the present disclosure may be disposed at a back surface of a display panel 110, and may include a piezoelectric element 120 and an amplifying member 130. The piezoelectric element 120 is driven to generate vibration, and may be attached to a back surface of the amplifying member 130. In addition, the amplifying member 130 may serve to amplify vibration generated by the driving of the piezoelectric element 120 and transmit the vibration to the display panel 110. Here, the display panel 110 may include a plastic organic light emitting diode (POLED) panel.

Liquid crystal displays (LCDs) are not self-emissive and thus require a backlight unit to provide light. The backlight unit is a device that evenly supplies light supplied from a light source to liquid crystals located at the front surface. As the backlight unit becomes thinner, thin LCDs can be implemented, but it is difficult to implement the backlight unit with a flexible material, and if the backlight unit is bent, it is difficult to supply light evenly to liquid crystals, thereby nonuniform screen brightness.

On the other hand, in the case of LEDs (light emitting diodes) or OLEDs (organic light emitting diodes), each element that constitutes a pixel emits light by itself (self-emission), so that this element can be implemented to be bent without using a backlight unit. In addition, since each element emits light on its own, even if the positional relationship with neighboring elements changes, such changed positions do not affect brightness of the elements, thereby implementing a bendable display.

The LED panel is implemented by technology that uses one LED element as one pixel, and it is possible to implement a bendable display because the size of each LED can be reduced compared to the related art. In addition, the POLED panel can implement a display that can be bent, folded, or rolled by using a flexible plastic substrate such as polyethylene terephthalate (PET) instead of glass.

In the case of the LCD panel, the piezoelectric element is located on the back of a bezel of the LCD panel to implement haptic feedback. This is because the propagation efficiency of vibration can be deteriorated due to an air layer present between laminated layers of the LCD panel.

In addition, the vibration generated by the piezoelectric element located on the bezel of the LCD panel may be propagated in a horizontal direction of the LCD panel. However, as described above, the piezoelectric element has limitations in such vibration that can be generated depending on the material or shape of the piezoelectric element or the magnitude of a voltage applied to the piezoelectric element.

On the other hand, unlike LCD panels, there is no air layer between the stacked layers of the POLED panel, depending on the method for manufacturing the POLED panel. Therefore, even if the haptic actuator 100 is located at the back surface of the POLED panel instead of the bezel portion, propagation efficiency of vibration generated by the piezoelectric element 120 may not deteriorate. Hereinafter, a method for amplifying vibration caused by the piezoelectric element 120 through the amplifying member 130 of the present disclosure will be described in more detail.

In the haptic actuator 100 according to one embodiment of the present disclosure, the amplifying member 130 may be attached to the back of the display panel 110 with both corners 131 in the first direction (X-axis direction), and may be spaced apart from the back surface of the display panel 110, resulting in formation of a gap. That is, since the center of the amplifying member 130 is spaced from the back surface of the display panel 110, vibration to be transmitted in a direction perpendicular to the display panel 110 (Y-axis direction) can be amplified. Accordingly, the haptic effect can be improved through vibration to be transmitted to the display panel 110 in each of a horizontal direction (X-axis direction) and a vertical direction (Y-axis direction).

Referring to FIGS. 1 and 2, in the haptic actuator 100 according to one embodiment of the present disclosure, the amplifying member 130 may be bent to have a predetermined radius of curvature. In addition, a thickness of the amplifying member 130 may become thicker from the center to the two corners 131 so that the attachment surfaces of the two corners 131 are parallel to the back surface of the display panel 110. That is, t2 may have a larger value than t1 of FIG. 2.

In addition, the piezoelectric element 120 may be bent to have the same radius of curvature as the amplifying member 130. That is, the piezoelectric element 120 may be bent to have the same radius of curvature as the amplifying member 130 in order to be attached to the back surface of the amplifying member 130 that is bent to have a predetermined radius of curvature.

Here, the radius of curvature of the amplifying member 130 may be 133 millimeters or more. As the radius of curvature increases, the attachment area of the piezoelectric element 120 and the amplifying member 130 can increase, making it easier to transmit vibration generated by the piezoelectric element 120 to the display panel 110 through the amplifying member 130.

In addition, as the radius of curvature decreases, a distance between the back surface of the display panel 110 and the front surface of the amplifying member 130 increases, which may be advantageous in amplifying the vibration transmitted in the vertical direction to the display panel 110 described above. However, considering the rigidity against bending of the piezoelectric element 120, a minimum radius of curvature of the amplifying member 130 in the haptic actuator 100 may be 133 millimeters.

In addition, considering the radius of curvature and the rigidity against bending of the piezoelectric element 120 described above, the thickness (t3) of the piezoelectric element 120 in the haptic actuator 100 may be 0.3 millimeters or more. However, as the piezoelectric element 120 becomes thicker, the capacitance may decrease, which may deteriorate the performance of the piezoelectric element 120. Accordingly, the haptic actuator 100 according to the present disclosure may have a thickness of the piezoelectric element 120 of 0.5 millimeters or less in consideration of the performance aspect of the piezoelectric element 120.

In addition, the haptic actuator 100 according to the present disclosure may have a vertical distance (d1) from the back surface of the display panel 110 to the back surface of the piezoelectric element 120 of 5 millimeters or less, as shown in FIG. 1. This is to solve the problem that the size or thickness of conventional amplifying structures for vibration becomes large, and to improve the haptic effect by amplifying the vibration while reducing the thickness of the haptic actuator 100 to 5 millimeters or less through the shape of the amplifying member 130 described above.

In addition, the amplifying member 130 in the haptic actuator 100 according to the present disclosure may include a metal material or a plastic material. This is because the rigidity or elastic coefficient of the amplifying member 130 is related to the amplification of vibration.

That is, as the rigidity or elastic modulus of the amplifying member 130 increases, the vibration may be easily amplified. Therefore, as an embodiment of the present disclosure, the metal material may include an aluminum material having strong rigidity. In addition, since the haptic actuator 100 can amplify the vibration generated by the piezoelectric element 120 through the shape of the amplifying member 130, the amplifying member 130 may include not only a metal material or a plastic material, but also other materials having rigidity or elasticity.

In addition, the haptic actuator 100 according to the present disclosure may further include an adhesive member 140 that attaches the piezoelectric element 120 to the back surface of the amplifying member 130 and attaches the corner portions 131 on both sides of the amplifying member 130 to the back surface of the display panel 110.

Here, according to one embodiment of the present disclosure, hardness of the adhesive member 140 may be 3 GPa or more in order to amplify the vibration. In addition, according to one embodiment of the present disclosure, the adhesive member 140 may be applied between the back surface of the piezoelectric element 120 with a thickness of 100 micrometers or more and 250 micrometers or less, and may be applied between the back surface of the display panel 110 and both corners 131 of the amplifying member 130 with a thickness of 100 micrometers or more and 250 micrometers or less.

FIGS. 3 and 4 are diagrams illustrating dimensions of the piezoelectric element 120 for use in the haptic actuator 100 according to one embodiment of the present disclosure.

The haptic actuator 100 according to the present disclosure needs to secure a predetermined area so that a resonant frequency of about 60 kHz may occur. Referring to FIG. 2 together, the length (L1) of the piezoelectric element 120 in the first direction (X-axis direction) may be 30 millimeters, and the length (L2) in the second direction (Z-axis direction) perpendicular to the first direction may be 30 millimeters.

In addition, in order to generate a resonant frequency of about 60 kHz, the length (L1) in the first direction (X-axis direction) may be 30 millimeters, and the length (L2) in the second direction (Z-axis direction) may be 30 millimeters or more. Therefore, referring to FIGS. 3 and 4, the length (L3) of the amplifying member 130 and the piezoelectric element 120 in the second direction (Z-axis direction) may be formed to be 30 millimeters or more, thereby securing a sufficient area on the back surface of the display panel 110, resulting in improvement of the haptic effect.

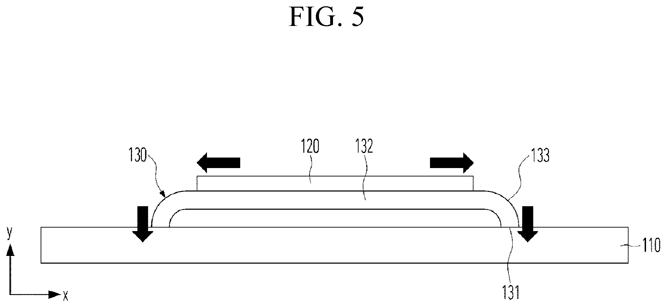

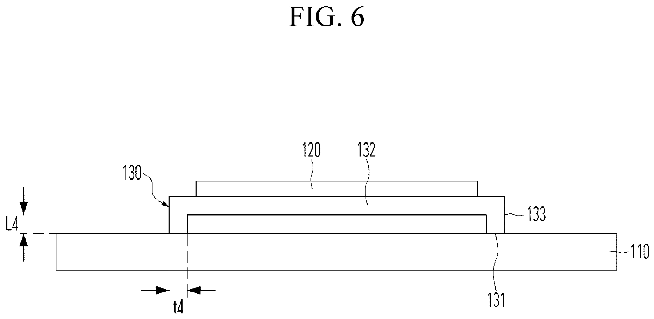

FIG. 5 is a diagram illustrating amplification of vibration caused by driving the piezoelectric element 120 through the amplifying member 130 of the haptic actuator 100 according to one embodiment of the present disclosure. FIGS. 6 to 8 are diagrams illustrating other embodiments of the haptic actuator 100 of the present disclosure.

In the haptic actuator 100 according to one embodiment of the present disclosure, the amplifying member 130 may include a flat portion 132 formed with a flat back surface, and a support portion 133 bent at a boundary of both sides of the flat portion 132 so that the attachment surfaces of both corners 131 are parallel to the back surface of the display panel 110.

That is, as described above with reference to FIGS. 1 to 4, the haptic actuator 100 according to the present disclosure can amplify vibration transmitted in a direction (Y-axis direction) perpendicular to the display panel 110 because the center of the amplifying member 130 is spaced apart from the back surface of the display panel 110. Therefore, the haptic effect can be improved through vibration transmitted in a horizontal direction (X-axis direction) and a vertical direction (Y-axis direction) to the display panel 110.

At this time, as described above, there may be a limitation in the rigidity of the amplifying member 130 and the piezoelectric element 120 that are bent to have a predetermined radius of curvature, and it may be difficult to attach both corners of the amplifying member 130 to the back surface of the display panel. Considering these points, various embodiments regarding the shape of the amplifying member 130 are illustrated in FIGS. 5 to 8. That is, the various embodiments of the present disclosure illustrated in FIGS. 5 to 8 can amplify vibrations even without bending the piezoelectric element 120. In addition, the thickness of the piezoelectric element 120 and the amplifying member 130 in the various embodiments of the present disclosure illustrated in FIGS. 5 to 8 can be freely set.

First, as illustrated in FIG. 5, in the haptic actuator 100 according to one embodiment of the present disclosure, the support portion 133 of the amplifying member 130 may be formed to have a predetermined radius of curvature at a boundary of both sides of the flat portion 132. At this time, the radius of curvature of the support portion 133 may be less than or equal to half a wavelength of the vibration generated by the piezoelectric element 120. In addition, the thickness of the flat portion 132 of the amplifying member 130 may be less than or equal to half a wavelength of vibration generated by the piezoelectric element 120. In addition, the front surface of the flat portion 132 of the amplifying member 130 is spaced apart from the back surface of the display panel 110, so that the vibration generated by the piezoelectric element 120 can be amplified, thereby improving the haptic effect.

In addition, as illustrated in FIG. 6, in the haptic actuator 100 according to the present disclosure, the support portion 133 of the amplifying member 130 may be vertically bent at a boundary of both sides of the flat portion 132. At this time, the thickness (t4) of the support portion 133 may be 1 millimeter or more, and may be less than half a wavelength of vibration generated by the piezoelectric element 120. This thickness may be a value for amplifying such vibration while stably supporting the flat portion 132 through the support portion 133.

The vertical distance (L4) from the back surface of the display panel 110 to the front surface of the flat portion 132 (i.e., the length of the support portion 133) may be less than half the wavelength of vibration generated by the piezoelectric element 120. As a result, since the front surface of the flat portion 132 of the amplifying member 130 is spaced apart from the back surface of the display panel 110, the vibration generated by the piezoelectric element 120 may be amplified to improve the haptic effect.

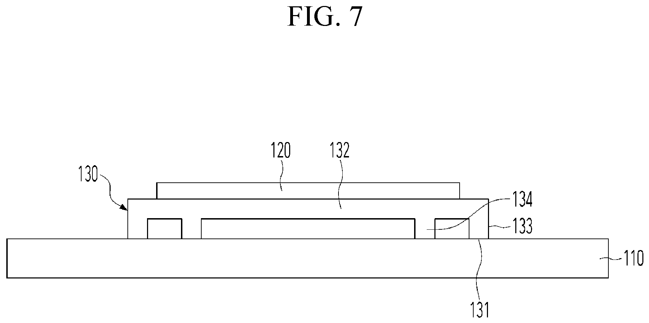

In addition, as illustrated in FIG. 7, the haptic actuator 100 according to the present disclosure may further include at least one support leg 134 formed vertically on the front surface of the flat portion 132 and attached to the back surface of the display panel 110. Referring to FIG. 5, the support leg 134 may further amplify the vibration to be transmitted in the direction (Y-axis direction) perpendicular to the display panel 110. Accordingly, since the front surface of the flat portion 132 of the amplifying member 130 is spaced apart from the back surface of the display panel 110, the vibration generated by the piezoelectric element 120 may be amplified to improve the haptic effect.

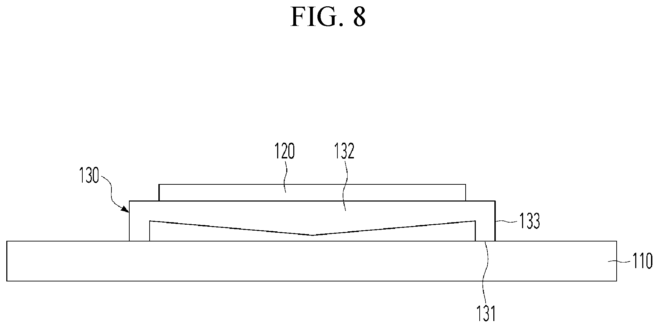

In addition, as shown in FIG. 8, in the haptic actuator 100 according to the present disclosure, the thickness of the central portion may be different from the thickness of a boundary portion of both sides of the flat portion 132. This is because the front surface of the flat portion 132 is spaced apart from the back surface of the display panel 110, and the vibration generated by the piezoelectric element 120 can be amplified through the support portion 133 vertically bent at both sides of the flat portion 132. That is, referring to FIG. 8, the haptic actuator 100 according to the present disclosure may implement the amplifying member 130 in various shapes, so that the vibration generated by the piezoelectric element 120 is amplified to improve the haptic effect.

In summary, the haptic actuator according to the present disclosure may amplify the vibration caused by the driving of the piezoelectric element by positioning the amplifying member having the piezoelectric element attached to the back surface of the amplifying member on the back surface of the display panel. In addition, both corners of the amplifying member are attached to the back surface of the display panel, and the front surface of the amplifying member may be formed in various shapes so that the front surface of the amplifying member can be spaced apart from the back surface of the display panel, thereby amplifying vibration caused by driving the piezoelectric element. The haptic actuator according to the present disclosure can reduce the thickness of the amplifying member and at the same time can amplify vibration caused by driving of the piezoelectric element.

The above detailed description is to be construed in all aspects as illustrative and not restrictive. The scope of the present disclosure should be determined by reasonable interpretation of the appended claims and all changes coming within the equivalency range of the present disclosure are intended to be embraced in the scope of the present disclosure.

## Claims

1. A haptic actuator (100) located at a back surface of a display panel (100) comprising:
a piezoelectric element (120) driven to generate vibration; and
an amplifying member (130) having the piezoelectric element (120) attached to a back surface thereof and configured to amplify vibration caused by driving of the piezoelectric element (120) and transmit the amplified vibration to the display panel (110),
wherein the amplifying member (130) is configured such that both corners (131) in a first direction are attached to the back surface of the display panel (110) and a front surface of the amplifying member (130) is spaced apart from the back surface of the display panel (110) to form a gap.

2. The haptic actuator (100) according to claim 1, wherein:
the amplifying member (130) is bent to have a predetermined radius of curvature; and
a thickness of the amplifying member (130) increases in a direction from a center portion to corners (131) of both sides of the amplifying member (130) so that attachment surfaces of the corners (131) of both sides of the amplifying member (130) are parallel to the back surface of the display panel (110).

3. The haptic actuator (100) according to claim 2, wherein:
the piezoelectric element (120) is bent to have a same radius of curvature as the amplifying member (130).

4. The haptic actuator (100) according to claim 3, wherein:
a vertical distance from the back surface of the display panel (110) to a back surface of the piezoelectric element (120) is 5 millimeters or less.

5. The haptic actuator (100) according to claim 3, wherein:
the radius of curvature of the amplifying member (130) is 133 millimeters or more.

6. The haptic actuator (100) according to claim 1, wherein the amplifying member (130) includes:
a flat portion (132) where the back surface is formed flat; and
a support portion (133) formed to be bent at a boundary of both sides of the flat portion (132) so that attachment surfaces of the corners (131) of both sides of the amplifying member (130) are parallel to the back surface of the display panel (110).

7. The haptic actuator (100) according to claim 6, wherein:
the support portion (133) is bent to have a predetermined radius of curvature at a boundary of both sides of the flat portion (132),
wherein
the radius of curvature of the support portion (133) is less than or equal to half a wavelength of the vibration generated by the piezoelectric element (120).

8. The haptic actuator (100) according to claim 6, wherein:
the support portion (133) is vertically bent at a boundary of both sides of the flat portion (132),
wherein
a thickness of the support portion (133) is 1 millimeter or more and less than or equal to half a wavelength of the vibration generated by the piezoelectric element (120).

9. The haptic actuator (100) according to claim 8, wherein:
a vertical distance from the back surface of the display panel (110) to the front surface of the flat portion (132) is less than or equal to half a wavelength of the vibration generated by the piezoelectric element (120).

10. The haptic actuator (100) according to claim 9, further comprising:
at least one support leg (134) formed vertically on a front surface of the flat portion (132) and attached to the back surface of the display panel (110).

11. The haptic actuator (100) according to claim 6, wherein:
the flat portion (132) is formed so that a thickness of a center portion of the flat portion (132) is different from a thickness of a boundary of both sides of the flat portion (132).

12. The haptic actuator (100) according to claim 1, wherein:
the piezoelectric element (120) has a thickness of 0.3 mm to 0.5 mm.

13. The haptic actuator (100) according to claim 12, wherein:
a length of the piezoelectric element (120) in the first direction is 30 millimeters.

14. The haptic actuator (100) according to claim 1, wherein:
the amplifying member (130) includes a metal material or a plastic material.

15. The haptic actuator (100) according to claim 1, further comprising:
an adhesive member (140) configured to attach the piezoelectric element (120) to the back surface of the amplifying member (130) and to attach corners (131) of both sides of the amplifying member (130) to the back surface of the display panel (110).

16. The haptic actuator (100) according to claim 1, wherein:
the display panel (110) is a plastic organic light emitting diode (POLED) panel.
